# EUROPEAN PATENT SPECIFICATION

(11) **EP 1 676 869 B1**
(45) Date of publication and mention of the grant of the patent: **14.10.2009**
(21) Application number: 04746314.6
(22) Date of filing: 17.06.2004
(51) Int. Cl.: C08F 220/10, C08F 22/20, C08F 220/28, C08L 33/14, G03F 7/039

(54) **PHOTORESIST RESIN AND PHOTORESIST RESIN COMPOSITION**
PHOTORESISTHARZ UND PHOTORESISTHARZZUSAMMENSETZUNG
RESINE PHOTOSENSIBLE ET COMPOSITION A BASE D'UNE RESINE PHOTOSENSIBLE

(30) Priority: 14.10.2003 JP 2003354224
(43) Date of publication of application: 05.07.2006
(73) Proprietor: Daicel Chemical Industries, Ltd., Kita-ku, Osaka-shi Osaka 530-0001 (JP)
(72) Inventor: KAMBARA, Shigeki, Hyogo, 6711212 (JP); KISHIMURA, Masaaki, 6750111 (JP)
(74) Representative: Grünecker, Kinkeldey, Stockmair & Schwanhäusser Anwaltssozietät
(86) International application number: PCT/JP2004/008845
(87) International publication number: WO 2005/035602

(56) References cited:
- EP-A1- 1 584 634
- JP-A- 2000 026 446
- JP-A- 2001 278 919
- JP-A- 2002 311 590
- JP-A- 2003 084 436
- JP-A- 2003 221 403

## Description

The present invention relates to a process for preparing a photoresist resin that is useful for the preparation of photoresist resin compositions typically used in fine patterning of semiconductors.

### Background Art

Positive photoresists for use in manufacturing processes of semiconductors must concurrently have different characteristics such as a characteristic that an exposed portion is made soluble in alkali by the application of light, adhesion to silicon wafers, plasma-etching resistance, and transparency to light used. The positive photoresists are generally used as a solution containing a base polymer, a light-activatable acid generator, and several types of additives for controlling the above characteristics. The wavelength of a light source for light irradiation in lithography for use in semiconductor manufacturing becomes shorter and shorter in recent years, and ArF excimer laser with a wavelength of 193 nm is promising as a next-generation light source. Various polymers containing a constitutional repeating unit having a group capable of partially leaving by the action of an acid to thereby become soluble in an alkali, and a constitutional repeating unit containing an alicyclic skeleton having a polar group have been proposed as resist polymers for use in the ArF excimer laser exposure system, for example in Japanese Unexamined Patent Application Publications No. 2000-26446 and No. 09-73137.

These polymers are generally prepared by polymerizing a mixture of monomers and separating the target polymers by precipitating the polymerization reaction mixture. When these polymers are to be dissolved in solvents for resist, however, part of them remains insoluble to cause turbidity, although major part of them are dissolved. The insoluble matter may cause troubles or problems in manufacturing processes of semiconductors and must be removed by filtration. However, the insoluble matter comprises fine particles and it takes much time and efforts to remove them by filtration.

JP-A-2000-026446 discloses a photoresist composition comprising a polymer obtained by stirring mixed solutions each containing a monomer, a polymerization initiator, and a solvent.

JP-A-2002-311590 discloses a radiation-sensitive resin composition for forming a fine line pattern, said composition comprising (A) an alkali-insoluble or slightly alkali-soluble resin, which becomes alkali-soluble under the action of an acid, (B) a radiation-sensitive acid generator, and (C) a polycyclic compound having a functional group. In the examples of JP-A-2002-311590, polymers are obtained by stirring mixed solutions each containing a monomer, a polymerization initiator, and a solvent.

EP-A-1584634 (prior art in accordance with Article 54(3) EPC) discloses a resin for a photoresist. The resin has a weight-average molecular weight of from 1,000 to 500,000. In the examples of EP-A-1584634, polymers are produced by adding dropwise a mixed solution containing a monomer, a polymerization initiator, and a solvent to a solvent in a reactor.

The object of the present invention is to provide a process for preparing a photoresist resin that is highly soluble in a solvent for resist.

After intensive investigations to achieve the above object, the present inventors have found (i) that, when a photoresist resin for an ArF excimer laser system is synthetically prepared by dropping polymerization, the resulting polymer exhibits a relatively narrow distribution in molecular weight and has a weight-average molecular weight within a range of 3000 to 15000, but even this polymer causes turbidity (insoluble matter) when dissolved in a solvent for resist; (ii) that the content of polymers (polymer fractions) each having a molecular weight exceeding a specific level (4×10⁴) can be significantly reduced by adding a solution of monomers and a solution of a polymerization initiator dropwise from different vessels in dropping polymerization; and (iii) that a resin thus prepared has a content of polymer fractions each having a molecular weight exceeding a specific level (4×10⁴) at a specific level (4 percent by weight) or less is easily dissolved in a solvent for resist and is free from turbidity. The present invention has been accomplished based on these findings.

The present invention provides a process for preparing a photoresist resin comprising at least a constitutional repeating unit A containing a group capable of partially leaving by the action of an acid to thereby become soluble in an alkali; and a constitutional repeating unit B containing an alicyclic skeleton having a polar group, wherein the resin has a weight-average molecular weight of 3000 to 15000 and has a content of polymer fractions each having a molecular weight exceeding 40000 of 4 percent by weight or less of the total resin, said process comprising the step of adding a solution of monomers and a solution of a polymerization initiator dropwise from different vessels in dropping polymerization, said solution of monomers comprising a monomer "a" corresponding to the constitutional repeating unit A, and a monomer "b" corresponding to the constitutional repeating unit B.

According to a preferred embodiment of the present invention the constitutional repeating unit A is at least one selected from constitutional repeating units of the following Formulae (Ia), (Ib) and (Ic): 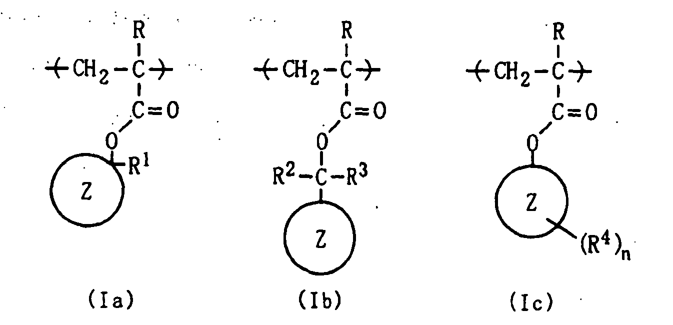 wherein the ring Z is an alicyclic hydrocarbon ring having six to twenty carbon atoms which may be substituted; R is a hydrogen atom or an alkyl group having one to six carbon atoms; R¹, R² and R³ may be the same as or different from one another and are each an alkyl group having one to six carbon atoms; R⁴s are substituents combined with the ring Z, may be the same as or different from each other and are each an oxo group, an alkyl group, a hydroxyl group which may be protected by a protective group, a hydroxyalkyl group which may be protected by a protective group, or a carboxyl group which may be protected by a protective group, and wherein at least one of nR⁴s is a -COOR^{a} group, wherein R^{a} is a tertiary hydrocarbon group which may be substituted, a tetrahydrofuranyl group, a tetrahydropyranyl group or an oxepanyl group; and n is an integer of 1 to 3.

According to another preferred embodiment of the present invention the constitutional repeating unit B is at least one selected from constitutional repeating units of the following Formulae (IIa), (IIb), (IIc), (IId) and (IIe): 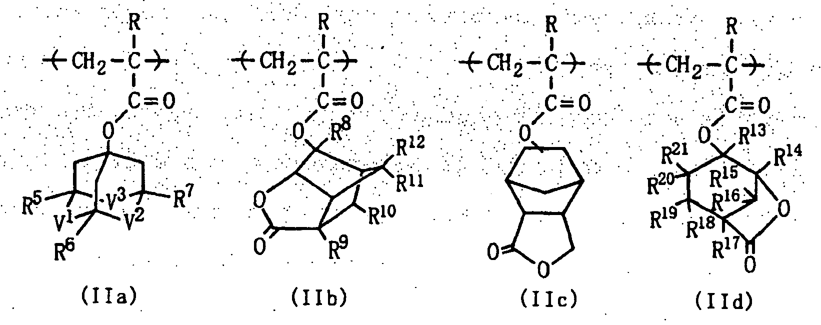 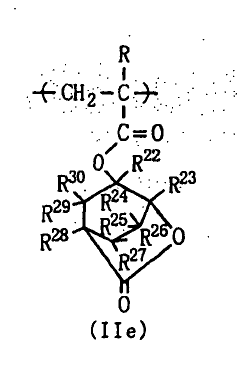 wherein R is a hydrogen atom or an alkyl group having one to six carbon atoms; R⁵, R⁶ and R⁷ may be the same as or different from one another and are each a hydrogen atom, an alkyl group, a hydroxyl group which may be protected by a protective group, a hydroxyalkyl group which may be protected by a protective group, or a carboxyl group which may be protected by a protective group; V¹, V² and V³ may be the same as or different from one another and are each -CH₂-, -CO- or -COO-, wherein (i) at least one of V¹, V² and V³ is - CO- or -COO-, or (ii) at least one of R⁵, R⁶ and R⁷ is a hydroxyl group which may be protected by a protective group, a hydroxyalkyl group which may be protected by a protective group, or a carboxyl group which may be protected by a protective group; R⁸, R⁹, R¹⁰, R¹¹ and R¹² may be the same as or different from one another and are each a hydrogen atom, an alkyl group, a hydroxyl group which may be protected by a protective group, a hydroxyalkyl group which may be protected by a protective group, or a carboxyl group which may be protected by a protective group; R¹³, R¹⁴, R¹⁵, R¹⁶, R¹⁷, R¹⁸, R¹⁹, R²⁰ and R²¹ may be the same as or different from one another and are each a hydrogen atom, an alkyl group, a hydroxyl group which may be protected by a protective group, a hydroxyalkyl group which may be protected by a protective group, or a carboxyl group which may be protected by a protective group; and R²², R²³, R²⁴, R²⁵, R²⁶, R²⁷, R²⁸ R²⁹ and R³⁰ may be the same as or different from one another and are each a hydrogen atom, an alkyl group, a hydroxyl group which may be protected by a protective group, a hydroxyalkyl group which may be protected by a protective group, or a carboxyl group which may be protected by a protective group.

In the present description, the terms "acrylic" and "methacrylic" may be generically referred to as" (meth) acrylic", and the terms "acryloyl" and "methacryloyl" may be generically referred to as "(meth)acryloyl". Protective groups conventionally used in the field of organic synthesis can be used as the protective groups for, for example, hydroxyl group and carboxyl group.

The photoresist resin is very highly soluble in solvents for resist and contributes to efficient preparation of a photoresist resin composition, in which the step of filtrating solvent-insoluble matter can be omitted or simplified.

The photoresist resin comprises at least a constitutional repeating unit A containing a group capable of partially leaving by the action of an acid to thereby become soluble in an alkali, and a constitutional repeating unit B containing an alicyclic skeleton having a polar group.

The constitutional repeating unit A containing a group capable of partially leaving by the action of an acid to thereby become soluble in an alkali is not specifically limited, as long as it is a constitutional repeating unit, part of which will leave by the action of an acid generated from a light-activatable acid generator upon irradiation with light or radiation (a constitutional repeating unit having an acid-induced leaving group). Examples of the constitutional repeating unit A are constitutional repeating units corresponding to (meth)acrylic esters each containing an alicyclic hydrocarbon group having six to twenty carbon atoms and having a group capable of leaving by the action of an acid (constitutional repeating units formed by polymerization at carbon-carbon double bonds). The "(meth)acrylic esters each containing an alicyclic hydrocarbon group having six to twenty carbon atoms and having a group capable of leaving by the action of an acid" include a (meth) acrylic ester containing an alicyclic hydrocarbon group having six to twenty carbon atoms and having a tertiary carbon atom at the bonding site with an oxygen atom constituting the ester bond of the (meth)acrylic ester. The alicyclic hydrocarbon group may be bonded to the oxygen atom constituting the ester bond of the (meth) acrylic ester directly or with the interposition of a linkage group such as an alkylene group. The alicyclic hydrocarbon group having six to twenty carbon atoms may be a monocyclic hydrocarbon group or a polycyclic (bridged) hydrocarbon group. Typical examples of the units corresponding to the (meth) acrylic esters are units represented by Formulae (Ia) and (Ib).

The "(meth)acrylic esters each containing an alicyclic hydrocarbon group having six to twenty carbon atoms and having a group capable of leaving by the action of an acid" also include (meth) acrylic esters each having an alicyclic hydrocarbon group having six to twenty carbon atoms, wherein a -COOR^{a} group is bonded to the alicyclic hydrocarbon group directly or with the interposition of a linkage group, wherein R^{a} is a tertiary hydrocarbon group which may be substituted, tetrahydrofuranyl group, tetrahydropyranyl group or oxepanyl group. Examples of the tertiary hydrocarbon group in R^{a} of the -COOR^{a} group are t-butyl, t-amyl, 2-methyl-2-adamantyl, and (1-methyl-1-adamantyl)ethyl groups. Examples of substituents which the tertiary hydrocarbon group may have are halogen atoms, alkyl groups such as alkyl groups having one to four carbon atoms, a hydroxyl group which may be protected by a protective group, oxo group, and a carboxyl group which may be protected by a protective group. In R^{a}, the tetrahydrofuranyl group, the tetrahydropyranyl group and the oxepanyl group include 2-tetrahydrofuranyl group, 2-tetrahydropyranyl group and 2-oxepanyl group, respectively. Examples of the linkage group are alkylene groups such as linear or branched alkyl groups each having one to six carbon atoms. The alicyclic hydrocarbon group may be bonded to the oxygen atom constituting the ester bond of the (meth)acrylic ester directly or with the interposition of a linkage group such as an alkylene group. The alicyclic hydrocarbon group having six to twenty carbon atoms may be a monocyclic hydrocarbon group or a polycyclic (bridged) hydrocarbon group. Typical examples of the units corresponding to these (meth)acrylic esters are units represented by Formula (Ic).

Constitutional repeating units corresponding to (meth) acrylic esters each containing a lactone ring having an oxygen atom constituting an ester bond at the beta-position of the lactone ring, and at least one hydrogen atom at the alpha-position of the lactone ring (constitutional repeating units undergone polymerization at a carbon-carbon double bond), for example, can also be used as the constitutional repeating unit A containing a group capable of partially leaving by the action of an acid to thereby become soluble in an alkali. Each of these constitutional repeating units A can be used alone or in combination.

The constitutional repeating unit A is preferably at least one selected from constitutional repeating units of Formulae (Ia), (Ib) and (Ic). In Formulae (Ia), (Ib) and (Ic), the alicyclic hydrocarbon ring having six to twenty carbon atoms in Ring Z may be any of monocyclic rings and polycyclic rings such as fused rings and bridged rings. Typical examples of the alicyclic hydrocarbon ring are cyclohexane ring, cyclooctane ring, cyclodecane ring, adamantane ring, norbornane ring, norbornene ring, bornane ring, isobornane ring, perhydroindene ring, decalin ring, perhydrofluorene ring (tricyclo[7.4.0.0^{3,8}]tridecane ring), perhydroanthracene ring, tricyclo[5.2.1.0^{2,6}]decane ring, tricyclo[4.2.2.1^{2,5}]undecane ring and tetracyclo[4.4.0.1^{2,5}.1^{7,10}]dodecane ring. The alicyclic hydrocarbon ring may have one or more substituents. Examples of such substituents are alkyl groups including alkyl groups each having one to four carbon atoms such as methyl group; halogen atoms such as chlorine atom; a hydroxyl group which may be protected by a protective group; oxo group; and a carboxyl group which may be protected by a protective group. Ring Z is preferably, for example, a polycyclic alicyclic hydrocarbon ring (bridged hydrocarbon ring) such as adamantane ring.

Examples of the alkyl groups each having one to six carbon atoms as R in Formulae (Ia), (Ib) and (Ic), and as R¹, R² and R³ in Formulae (Ia) and (Ib) are linear or branched alkyl groups each having one to six carbon atoms, such as methyl, ethyl, propyl, isopropyl, butyl, isobutyl, s-butyl, t-butyl and hexyl groups. R is preferably hydrogen atom or an alkyl group having one to three carbon atoms, of which hydrogen atom or methyl group is typically preferred. Examples of the alkyl group as R⁴ in Formula (Ic) are linear or branched alkyl groups each having about one to about twenty carbon atoms, such as methyl, ethyl, propyl, isopropyl, butyl, isobutyl, s-butyl, t-butyl, hexyl, octyl, decyl and dodecyl groups. Examples of the hydroxyl group which may be protected by a protective group as R⁴ are hydroxyl group and substituted oxy groups including alkoxy groups each having one to four carbon atoms, such as methoxy, ethoxy and propoxy groups. Examples of the hydroxyalkyl group which may be protected by a protective group are groups each comprising the hydroxyl group which may be protected by a protective group combined with the interposition of an alkylene group having one to six carbon atoms. Examples of the carboxyl group which may be protected by a protective group are -COOR^{b} groups, wherein R^{b} is hydrogen atom or an alkyl group. Examples of the alkyl group herein are linear or branched alkyl groups each having one to six carbon atoms, such as methyl, ethyl, propyl, isopropyl, butyl, isobutyl, s-butyl, t-butyl and hexyl groups. R^{a} of the -COOR^{a} group in R⁴ is as defined above.

The constitutional repeating unit B containing an alicyclic skeleton having a polar group includes (1) monomer units B1 (constitutional repeating units formed by polymerization at carbon-carbon double bonds) corresponding to (meth)acrylic esters each having an alicyclic hydrocarbon group bonded to an oxygen atom constituting the ester bond, which alicyclic hydrocarbon group contains a lactone ring and has six to twenty carbon atoms. The alicyclic hydrocarbon group herein includes, for example, a group comprising a lactone ring fused with a monocyclic or polycyclic (bridged) alicyclic carbon ring. Typical examples of such constitutional repeating units B1 are units of Formula (IIa) wherein at least one of V¹, V² and V³ is -COO-, and units represented by Formulae (IIb), (IIc), (IId) and (IIe).

The constitutional repeating unit B containing an alicyclic skeleton having a polar group also includes (2) monomer units B2 (constitutional repeating units formed by polymerization at carbon-carbon double bonds) corresponding to (meth) acrylic esters each having an alicyclic hydrocarbon group bonded to an oxygen atom constituting the ester bond. The alicyclic hydrocarbon group herein contains a polar group such as hydroxyl group, carboxyl group or oxo group and has six to twenty carbon atoms. Among such alicyclic hydrocarbon groups, a bridged hydrocarbon group is preferred herein. Typical examples of such constitutional repeating units B1 are units of Formula (IIa) wherein at least one of V¹, V² and V³ is -CO-, or at least one of R⁵, R⁶ and R⁷ is a hydroxyl group which may be protected by a protective group, a hydroxyalkyl group which may be protected by a protective group, or a carboxyl group which may be protected by a protective group.

The constitutional repeating unit B imparts, to the resin, adherence typically with silicon wafers by the action of the polar group and dry etching resistance by the action of the alicyclic skeleton. Each of the constitutional repeating units B may be contained alone or in combination. The constitutional repeating unit B is preferably at least one selected from the constitutional repeating units Formulae (IIa), (IIb), (IIc), (IId) and (IIe). The combination use of the constitutional repeating unit B1 and the constitutional repeating unit B2 can advantageously yield a resin which exhibits well-balanced properties such as substrate adherence, dry etching resistance and solubility in solvents for resist and has excellent and uniform reactivity in polymerization. Namely, the resulting polymer is highly uniform in its molecular weight and molecular structure.

R in Formulae (IIa), (IIb), (IIc), (IId) and (IIe) is has the same meaning as R in Formulae (Ia), (Ib) and (Ic). In Formulae (IIa) through (IIe), examples of the alkyl groups as R⁵ through R³⁰ are linear or branched alkyl groups each having one to thirteen carbon atoms, such as methyl, ethyl, propyl, isopropyl, butyl, isobutyl, s-butyl, t-butyl, hexyl, octyl, decyl and dodecyl groups. Among them, alkyl groups each having one to four carbon atoms are preferred. Examples of the hydroxyl group which may be protected by a protective group are hydroxyl group and substituted oxy groups including alkoxy groups each having one to four carbon atoms, such as methoxy, ethoxy and propoxy groups. Examples of the hydroxyalkyl group which may be protected by a protective group are groups each comprising the hydroxyl group which may be protected by a protective group combined with the interposition of an alkylene group having one to six carbon atoms. Examples of the carboxyl group which may be protected by a protective group are -COOR^{b} groups, wherein R^{b} is as defined above.

The photoresist resin may further comprise any of other constitutional repeating units in addition to the constitutional repeating units A and B, within ranges not adversely affecting the properties such as solubility in an alkali (leaving property by the action of an acid), substrate adherence, dry etching resistance and solubility in solvents for resist. Such other constitutional repeating units are not specifically limited, as long as they are units corresponding to monomers copolymerizable with monomers corresponding to the constitutional repeating unit A and with monomers corresponding to the constitutional repeating unit B and do not adversely affect the properties of the resist. Examples of such units are units corresponding to (meth)acrylic acid or derivatives thereof, maleic acid or derivatives thereof, fumaric acid or derivatives thereof, and cyclic olefins. Examples of the (meth)acrylic acid or derivatives thereof are (meth)acrylic esters each having a lactone ring such as γ-butyrolactone ring or δ-valerolactone ring. Specific examples thereof are α-(meth)acryloyloxy-γ-butyrolactone, α-(meth)acryloyloxy-α-methyl-γ-butyrolactone and α-(meth)acryloyloxy-γ,γ-dimethyl-γ-butyrolactone. These (meth)acrylic esters each having a lactone ring can impart, to the polymer, adherence to a substrate.

The content of the constitutional repeating unit A in the photoresist resin is, for example, from 5 to 90 percent by mole, preferably from 10 to 80 percent by mole, and more preferably from 20 to 70 percent by mole. A content of the constitutional repeating unit A less than 5 percent by mole may invite insufficient dissolution of the resulting resist film in alkali development and may reduce the resolution to thereby fail to produce fine patterns with good accuracy. A content of the constitutional repeating unit A exceeding 90 percent by mole may reduce adherence to a substrate and dry etching resistance and may often invite peeling off of the resulting pattern as a result of development.

The content of the constitutional repeating unit B in the photoresist resin is, for example, from 10 to 95 percent by mole, preferably from 20 to 90 percent by mole, and more preferably from 30 to 80 percent by mole. A content of the constitutional repeating unit B less than 10 percent by mole may often reduce adherence to a substrate and dry etching resistance. A content of the constitutional repeating unit B exceeding 95 percent by mole may often invite insufficient dissolution of the resist film in alkali development. The ratio of the constitutional repeating unit B1 to the constitutional repeating unit B2, if used in combination, is not specifically limited but is generally from 5/95 to 95/5, preferably from 10/90 to 90/10, and more preferably from 30/70 to 70/30 in terms of molar ratio.

One of the key features of the photoresist resin is that the resin has a weight-average molecular weight (Mw) of 3000 to 15000 and has a content of polymer fractions each having a molecular weight exceeding 40000 of 4 percent by weight or less (preferably 3 percent by weight or less, and more preferably 2 percent by weight or less). If the weight-average molecular weight is less than 3000, a desired film strength is not obtained in the formation of a resist film. If the weight-average molecular weight exceeds 15000, the resulting photoresist resin composition has an excessively high viscosity as a solution, which invites decreased workability and fails to produce a uniform, good coating. The weight-average molecular weight is preferably from 4000 to 14000, and more preferably from 5000 to 13000. If the content of polymer fractions each having a molecular weight exceeding 40000 exceeds 4 percent by weight, the resin invites insoluble matter (turbidity) when dissolved in a solvent for resist. If such an insoluble matter hardly soluble in a resist solvent is contained in the photoresist resin, a uniform resist film of homogenous quality is not obtained, the sensitivity and resolution decrease, and a desired pattern cannot be significantly prepared with good accuracy. To avoid this, the insoluble matter must be removed by filtration. However, the insoluble matter is generally in the form of fine particles (colloid), and it takes much time and efforts to remove it by filtration. This inhibits efficient production of a photoresist resin composition. The molecular weight distribution (Mw/Mn) of the photoresist resin is, for example, from 1.1 to 3.5 and preferably from 1.5 to 3.0, wherein Mn is a number-average molecular weight, and Mn and Mw are in terms of polystyrene. The weight-average molecular weight, the content of polymer fractions each having a molecular weight exceeding 40000, and the molecular weight distribution can be determined by gel permeation chromatography (GPC).

The photoresist resin can be prepared, for example, by subjecting a monomer solution and a polymerization initiator solution to polymerization at 60°C to 130°C while adding these solutions dropwise from different vessels to a reactor. The monomer solution contains a monomer mixture at least comprising a monomer "a" having a group capable of partially leaving by the action of an acid to thereby become soluble in an alkali, and a monomer "b" containing an alicyclic skeleton having a polar group. The polymerization initiator solution contains a polymerization initiator

It is important to add the monomer solution and the polymerization initiator solution dropwise separately from different vessels to the reactor. This procedure enables the content of polymer fractions each having a molecular weight exceeding 40000 to be reduced to 4 percent by weight or less of the total polymers. In contrast, if a solution containing both the monomers and the polymerization initiator is added dropwise to the reactor, the polymerization of the monomers gradually proceeds in the dropping vessel before dropping to form polymer fractions each having a high molecular weight. Thus, the resulting polymer after the completion of the polymerization contains more than 4 percent by weight of polymer fractions each having a molecular weight exceeding 40000.

The polymerization temperature (temperature of a reaction mixture) in the dropping polymerization is preferably controlled so as to minimize the variation or deviation of the polymerization temperature. It is preferred, for example, to control the polymerization temperature (temperature of the reaction mixture) within ±5°C, more preferably within ±3°C of a preset temperature during 93 percent or more, more preferably 95 percent or more, of the total dropping time (adding time) of the monomer solution and the polymerization initiator solution. If the polymerization is carried out under such conditions that the polymerization temperature deviates from ±5°C of the preset temperature (the variation of the polymerization temperature exceeds ±5°C) during 7 percent or more of the total dropping time, the content of polymer fractions each having a molecular weight exceeding 40000 may often increase . Particularly, the deviation of the polymerization temperature may often increase in the early stages of the dropping, since the solutions to be dropped are generally at around room temperature, heat of polymerization generates in a small quantity at the beginning of the dropping, and thereby the polymerization temperature (temperature of the reaction mixture) once significantly falls down from the preset temperature of a control system. Based on this, the polymerization temperature should be preferably controlled within the above-specified narrow deviation, for example, by a process of controlling the temperature in the reactor (liquid temperature) at a temperature higher than the preset temperature before the dropping of the monomer solution and the polymerization initiator solution, and then starting dropping of the solutions. The temperature in the reactor may be set, for example, within a range of [(preset temperature)+1°C to (preset temperature)+5°C], and preferably within a range of [(preset temperature)+1°C to (preset temperature)+3°C].
According to this process, the system temperature begins to gradually decrease upon the initiation of the dropping of the monomer solution and the polymerization initiator solution. At the time when the system temperature reaches the vicinity of the target preset temperature, the temperature set in the control system is gradually reduced to the target preset temperature. Thus, the system temperature can be stabilized within the target preset temperatures within a short time while avoiding the system temperature from significantly falling below the preset temperature. This prevents polymer fractions each having a highmolecular weight exceeding 40000 from forming. In contrast, when the temperature in the reactor is controlled at the target preset temperature at the beginning of the dropping of the solutions, the system temperature falls below the preset temperature at the begging of the dropping. To cover this, the control system significantly leans toward heating, which causes an increased hunting in the temperature. Thus, the polymerization is carried out under such conditions that the polymerization temperature deviates from ±5°C of the preset temperature (the variation of the polymerization temperature exceeds ±5°C) during 7 percent or more (e.g., 30 minutes or more) of the total dropping time. This results in an increased content of polymer fractions each having a high molecular weight exceeding 40000, which exceeds 4 percent by weight of the total polymer.

A process for controlling the polymerization temperature within ±5°C of the preset temperature during 93 percent or more of the total dropping time is not limited to the above-mentioned process, and any other process can be employed. The temperature in the system can be prevented from varying, for example, by dropping the monomer solution and the polymerization initiator solution at low speed in the beginning, and gradually increasing the dropping speed.

The dropping polymerization,more specifically,is carried out by separately preparing a monomer solution comprising a monomer mixture dissolved in an organic solvent (a polymerization solvent), and a polymerization initiator solution comprising a polymerization initiator dissolved in an organic solvent (the polymerization solvent), placing the solutions into different vessels, and adding the monomer solution and the polymerization initiator solution dropwise concurrently to an organic solvent (polymerization solvent) controlled at a specific temperature, respectively. The monomer solution and the polymerization initiator solution are preferably added dropwise at the same rate (speed).

Examples of the polymerization solvent are glycol solvents, ester solvents, ketone solvents, ether solvents, amide solvents, sulfoxide solvents, monohydric alcohol solvents, hydrocarbon solvents, and mixtures of these solvents. Examples of the glycol solvents are propylene glycol solvents such as propylene glycol monomethyl ether and propylene glycol monomethyl ether acetate; and ethylene glycol solvents such as ethylene glycol monomethyl ether, ethylene glycol monomethyl ether acetate, ethylene glycol monoethyl ether, ethylene glycol monoethyl ether acetate, ethylene glycol monobutyl ether and ethylene glycol monobutyl ether acetate. Examples of the ester solvents are lactic ester solvents such as ethyl lactate; propionic ester solvents such as methyl 3-methoxypropionate; and acetic ester solvents such as methyl acetate, ethyl acetate, propyl acetate and butyl acetate. Examples of the ketone solvents are acetone, methyl ethyl ketone, methyl isobutyl ketone, methyl amyl ketone and cyclohexanone. Examples of the ether solvents are diethyl ether, diisopropyl ether, dibutyl ether, tetrahydrofuran and dioxane. The amide solvents include, for example, N,N-dimethylformamide. The sulfoxide solvents include, for example, dimethyl sulfoxide. Examples of the monohydric alcohol solvents are methanol, ethanol, propanol and butanol. Examples of the hydrocarbon solvents are toluene, xylenes, hexane and cyclohexane.

Preferred polymerization solvents include glycol solvents such as propylene glycol monomethyl ether and propylene glycol monomethyl ether acetate; ester solvents such as ethyl lactate; ketone solvents such as methyl isobutyl ketone and methyl amyl ketone; and mixtures of these solvents. Among them, typically preferred are solvents at least comprising propylene glycol monomethyl ether acetate, such as a solvent containing propylene glycol monomethyl ether acetate alone, a solvent mixture containing propylene glycol monomethyl ether acetate and propylene glycol monomethyl ether, and a solvent mixture containing propylene glycol monomethyl ether acetate and ethyl lactate.

Any known polymerization initiator can be used as the polymerization initiator herein.

In the dropping polymerization, the ratio of the amount of the solvent to be placed in the reaction system beforehand to the total amount of the solutions (the monomer solution and the polymerization initiator solution) to be added dropwise can be appropriately set in consideration typically of productivity, economical efficiency, workability and operability within ranges not adversely affecting the quality of the resin. In general, the ratio of the solvent to the total amount of the solutions is from 5/95 to 90/10, preferably from 10/90 to 70/30, and more preferably from 20/80 to 60/40 in terms of weight ratio. The total amount of the polymerization solvents to be used, i.e., the total amount of the solvent to be placed in before hand or the amount of the solvent in the solution with the amount of the solvents contained in the solutions to be added dropwise, can be appropriately set in consideration typically of workability, operability, reaction efficiency and solubility of the resulting polymer and is generally from 100 to 2000 parts by weight, preferably from 200 to 1000 parts by weight, and more preferably from 300 to 700 parts by weight, to 100 parts by weight of the total amount of the monomers.

The total dropping time for the monomer solution and the polymerization initiator solution may vary depending on, for example, the polymerization temperature and types of the monomers and is generally from one to ten hours, and preferably from three to eight hours. The polymerization temperature is difficult to control to thereby often increase the deviation of the polymerization temperature particularly in the first half of the dropping procedure of the monomer solution or the polymerization initiator solution (in the first half of the total dropping time). Accordingly, it is preferred to control the polymerization temperature within ±5°C, preferably within ±3°C, of the preset temperature during 95 percent or more in the first half of the dropping time in the dropping procedure of the monomer solution or the polymerization initiator solution. Aging may be carried out at an appropriate temperature (e.g., from 60°C to 130°C) for an appropriate time period (e.g., 0.1 to 10 hours, and preferably from 1 to 6 hours) to complete the polymerization.

The monomer "a" corresponds to the constitutional repeating unit A, and the monomer "b" corresponds to the constitutional repeating unit B. Such resins containing any of constitutional repeating units represented by Formulae (Ia), (Ib), (Ic), (IIa), (IIb), (IIc), (IId) and (IIe) can be prepared by subjecting corresponding (meth) acrylic esters as comonomers to polymerization.

### [Constitutional Repeating Units Represented by Formulae (Ia), (Ib) and (Ic)]

Monomers corresponding to the constitutional repeating units represented by Formulae (Ia), (Ib) and (Ic) are represented by following Formulae (1a), (1b) and (1c), respectively. There can be stereoisomers in the compounds represented by Formulae (1a), (1b) and (1c), and each of these compounds can be used alone or in combination as a mixture. 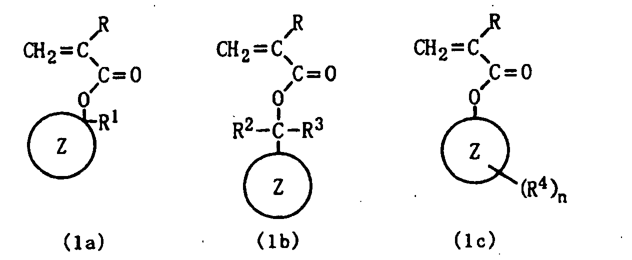 Wherein Ring Z is an alicyclic hydrocarbon ring having six to twenty carbon atoms which may be substituted; R is hydrogen atom or methyl group; R¹, R² and R³ may be the same as or different from one another and are each an alkyl group having one to six carbon atoms; R⁴s are substituents combined with Ring Z, may be the same as or different from each other and are each oxo group, an alkyl group, a hydroxyl group which may be protected by a protective group, a hydroxyalkyl group which may be protected by a protective group, or a carboxyl group which may be protected by a protective group, wherein at least one of nR⁴s is a -COOR^{a} group, wherein R^{a} is a tertiary hydrocarbon group which may be substituted, tetrahydrofuranyl group, tetrahydropyranyl group or oxepanyl group; and n is an integer of 1 to 3.

Typical examples of the compounds represented by Formula (1a) include the following compounds.
[1-1] 2-(Meth)acryloyloxy-2-methyladamantane (R is H or CH₃; R¹ is CH₃; and Z is adamantane ring)
[1-2] 1-Hydroxy-2-(meth)acryloyloxy-2-methyladamantane (Ris H or CH₃; R¹ is CH₃; and Z is adamantane ring having hydroxyl group at the 1-position)
[1-3] 5-Hydroxy-2-(meth)acryloyloxy-2-methyladamantane (R is H or CH₃; R¹ is CH₃; and Z is adamantane ring having hydroxyl group at the 5-position)
[1-4] 1,3-Dihydroxy-2-(meth)acryloyloxy-2-methyladamantane (R is H or CH₃; R¹ is CH₃; and Z is adamantane ring having hydroxyl groups at the 1- and 3-positions)
[1-5] 1,5-Dihydroxy-2-(meth)acryloyloxy-2-methyladamantane (R is H or CH₃; R¹ is CH₃; and Z is adamantane ring having hydroxyl groups at the 1- and 5-positions)
[1-6] 1,3-Dihydroxy-6-(meth)acryloyloxy-6-methyladamantane (R is H or CH₃; R¹ is CH₃; and Z is adamantane ring having hydroxyl groups at the 1- and 3-positions)
[1-7] 2-(Meth)acryloyloxy-2-ethyladamantane (R is H or CH₃; R¹ is CH₂CH₃; and Z is adamantane ring)
[1-8] 1-Hydroxy-2-(meth)acryloyloxy-2-ethyladamantane (R is H or CH₃; R¹ is CH₂CH₃; and Z is adamantane ring having hydroxyl group at the 1-position)
[1-9] 5-Hydroxy-2-(meth)acryloyloxy-2-ethyladamantane (R is H or CH₃; R¹ is CH₂CH₃; and Z is adamantane ring having hydroxyl group at the 5-position)
[1-10] 1,3-Dihydroxy-2-(meth)acryloyloxy-2-ethyladamantane (R is H or CH₃; R¹ is CH₂CH₃; and Z is adamantane ring having hydroxyl groups at the 1- and 3-positions)
[1-11] 1,5-Dihydroxy-2-(meth)acryloyloxy-2-ethyladamantane (R is H or CH₃; R¹ is CH₂CH₃; and Z is adamantane ring having hydroxyl groups at the 1- and 5-positions)
[1-12] 1,3-Dihydroxy-6-(meth)acryloyloxy-6-ethyladamantane (R is H or CH₃; R¹ is CH₂CH₃; and Z is adamantane ring having hydroxyl groups at the 1- and 3-positions)

Each of the compounds represented by Formula (1a) can be prepared, for example, by reacting a corresponding cyclic alcohol with (meth) acrylic acid or a reactive derivative thereof according to a conventional esterification procedure using an acid catalyst or a transesterification catalyst.

Typical examples of the compounds represented by Formula (1b) include the following compounds.
[1-13] 1-(1-(Meth)acryloyloxy-1-methylethyl)adamantane (R is H or CH₃; R² and R³ are CH₃; and Z is adamantane ring)
[1-14] 1-Hydroxy-3-(1-(meth)acryloyloxy-1-methylethyl)adamantane (R is H or CH₃; R² and R³ are CH₃; and Z is adamantane ring having hydroxyl group at the 1-position)
[1-15] 1-(1-Ethyl-1-(meth)acryloyloxypropyl)adamantane (Ris H or CH₃; R² and R³ are CH₂CH₃; and Z is adamantane ring)
[1-16] 1-Hydroxy-3-(1-ethyl-1-(meth)acryloyloxypropyl)adamantane (R is H or CH₃; R² and R³ are CH₂CH₃; and Z is adamantane ring having hydroxyl group at the 1-position) [1-17] 1-(1-(Meth)acryloyloxy-1-methylpropyl)adamantane (R is H or CH₃; R² is CH₃; R³ is CH₂CH₃; and Z is adamantane ring)
[1-18] 1-Hydroxy-3-(1-(meth)acryloyloxy-1-methylpropyl)adamantane (R is H or CH₃; R² is CH₃; R³ is CH₂CH₃; and Z is adamantane ring having hydroxyl group at the 1-position)
[1-19] 1-(1-(Meth)acryloyloxy-1,2-dimethylpropyl)adamantane (R is H or CH₃; R² is CH₃; R³ is CH(CH₃)₂; and Z is adamantane ring)
[1-20] 1-Hydroxy-3-(1-(meth)acryloyloxy-1,2-dimethylpropyl)adaman tane (R is H or CH₃; R² is CH₃; R³ is CH(CH₃)₂; and Z is adamantane ring having hydroxyl group at the 1-position)
[1-21] 1,3-Dihydroxy-5-(1-(meth)acryloyloxy-1-methylethyl)adamant ane (R is H or CH₃; R² and R³ are CH₃; and Z is adamantane ring having hydroxyl groups at the 1- and 3-positions)
[1-22] 1-(1-Ethyl-1-(meth)acryloyloxypropyl)-3,5-dihydroxyadamant ane (R is H or CH₃; R² and R³ are CH₂CH₃; and Z is adamantane ring having hydroxyl groups at the 3- and 5-positions)
[1-23] 1,3-Dihydroxy-5-(1-(meth)acryloyloxy-1-methylpropyl)adaman tane (R is H or CH₃; R² is CH₃; R³ is CH₂CH₃; and Z is adamantane ring having hydroxyl groups at the 1- and 3-positions)
[1-24] 1,3-Dihydroxy-5-(1-(meth)acryloyloxy-1,2-dimethylpropyl)ad amantane (R is H or CH₃; R² is CH₃; R³ is CH(CH₃)₂; and Z is adamantane ring having hydroxyl groups at the 1- and 3-positions)

Each of the compounds represented by Formula (1b) can be prepared, for example, by reacting a corresponding methanol derivative having an alicyclic group at the 1-position with (meth) acrylic acid or a reactive derivative thereof according to a conventional esterification procedure using an acid catalyst or a transesterification catalyst.

Typical examples of the compounds represented by Formula (1c) include the following compounds.
[1-25] 1-t-Butoxycarbonyl-3-(meth)acryloyloxyadamantane (R is H or CH₃; R⁴ is t-butoxycarbonyl group; n is 1; and Z is adamantane ring)
[1-26] 1,3-Bis(t-butoxycarbonyl)-5-(meth)acryloyloxyadamantane [R is H or CH₃; R⁴s are t-butoxycarbonyl groups; n is 2; and Z is adamantane ring]
[1-27] 1-t-Butoxycarbonyl-3-hydroxy-5-(meth)acryloyloxyadamantane (R is H or CH₃; R⁴s are OH and t-butoxycarbonyl group, respectively; n is 2; and Z is adamantane ring)
[1-28] 1-(2-Tetrahydropyranyloxycarbonyl)-3-(meth)acryloyloxyadam antane (R is H or CH₃; R⁴ is 2-tetrahydropyranyloxycarbonyl group; n is 1; and Z is adamantane ring)
[1-29] 1,3-Bis(2-tetrahydropyranyloxycarbonyl)-5-(meth)acryloylox yadamantane (R is H or CH₃; R⁴s are 2-tetrahydropyranyloxycarbonyl groups; n is 2; and Z is adamantane ring)
[1-30] 1-Hydroxy-3-(2-tetrahydropyranyloxycarbonyl)-5-(meth)acryl oyloxyadamantane (R is H or CH₃; R⁴s are OH and 2-tetrahydropyranyloxycarbonyl group, respectively; n is 2; and Z is adamantane ring)

Each of the compounds represented by Formula (1c) can be prepared, for example, by reacting a corresponding cyclic alcohol with (meth) acrylic acid or a reactive derivative thereof according to a conventional esterification procedure using an acid catalyst or a transesterification catalyst.

### [Constitutional Repeating Units Represented by Formulae (IIa), (IIb), (IIc), (IId) and (IIe)]

Monomers corresponding to the constitutional repeating units represented by Formulae (IIa), (IIb), (IIc), (IId) and (IIe) are represented by following Formulae (2a), (2b), (2c), (2d) and (2e), respectively. There can be stereoisomers in the compounds represented by Formulae (2a), (2b), (2c), (2d) and (2e), and each of these compounds can be used alone or in combination as a mixture. 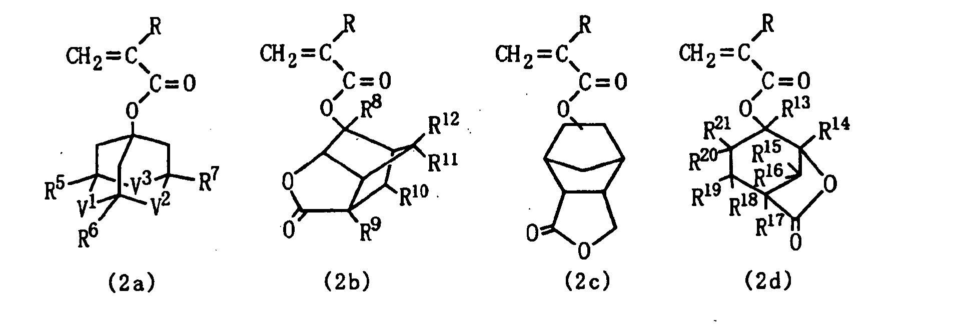 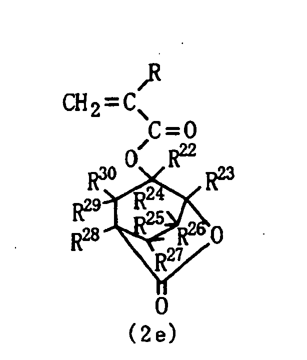 Wherein R is hydrogen atom or methyl group; R⁵, R⁶ and R⁷ may be the same as or different from one another and are each hydrogen atom, an alkyl group, a hydroxyl group which may be protected by a protective group, a hydroxyalkyl group which may be protected by a protective group, or a carboxyl group which may be protected by a protective group; V¹, V² and V³ may be the same as or different from one another and are each -CH₂-, -CO- or -COO-, wherein (i) at least one of V¹, V² and V³ is -CO- or -COO-, or (ii) at least one of R⁵, R⁶ and R⁷ is a hydroxyl group which may be protected by a protective group, a hydroxyalkyl group which may be protected by a protective group, or a carboxyl group which may be protected by a protective group; R⁸, R⁹, R¹⁰, R¹¹ and R¹² may be the same as or different from one another and are each hydrogen atom, an alkyl group, a hydroxyl group which may be protected by a protective group, a hydroxyalkyl group which may be protected by a protective group, or a carboxyl group which may be protected by a protective group; R¹³, R¹⁴, R¹⁵, R¹⁶, R¹⁷, R¹⁸, R¹⁹, R²⁰ and R²¹ may be the same as or different from one another and are each hydrogen atom, an alkyl group, a hydroxyl group which may be protected by a protective group, a hydroxyalkyl group which may be protected by a protective group, or a carboxyl group which may be protected by a protective group; and R²², R²³, R²⁴, R²⁵, R²⁶, R²⁷, R²⁸, R²⁹ and R³⁰ may be the same as or different from one another and are each hydrogen atom, an alkyl group, a hydroxyl group which may be protected by a protective group, a hydroxyalkyl group which may be protected by a protective group, or a carboxyl group which may be protected by a protective group.

Typical examples of the compounds represented by Formula (2a) include the following compounds.
[2-1] 1-(Meth)acryloyloxy-4-oxatricyclo[4.3.1.1^{3,8}]undecan-5-one (R is H or CH₃; R⁵, R⁶ and R⁷ are H; V² is -CO-O- (the left side is the side of the carbon atom to which R⁶ is bonded); and V¹ and V³ are -CH₂-)
[2-2] 1-(Meth)acryloyloxy-4,7-dioxatricyclo[4.4.1.1^{3,9}]dodecane-5 ,8-dione (R is H or CH₃; R⁵, R⁶ and R⁷ are H; V¹ is -CO-O- (the left side is the side of the carbon atom to which R⁵ is bonded); V² is -CO-O- (the left side is the side of the carbon atom to which R⁶ is bonded); and V³ is -CH₂-)
[2-3] 1-(Meth)acryloyloxy-4,8-dioxatricyclo[4.4.1.1^{3,9}]dodecane-5 ,7-dione (R is H or CH₃; R⁵, R⁶ and R⁷ are H; V¹ is -O-CO- (the left side is the side of the carbon atom to which R⁵ is bonded) ; V² is -CO-O- (the left side is the side of the carbon atom to which R⁶ is bonded); and V³ is -CH₂-)
[2-4] 1-(Meth)acryloyloxy-5,7-dioxatricyclo[4.4.1.1^{3,9}]dodecane-4 ,8-dione (R is H or CH₃; R⁵, R⁶ and R⁷ are H; V¹ is -CO-O- (the left side is the side of the carbon atom to which R⁵ is bonded) ; V² is -O-CO- (the left side is the side of the carbon atom to which R⁶ is bonded); and V³ is -CH₂-)
[2-5] 1-(Meth)acryloyloxy-3-hydroxyadamantane (R is H or CH₃; R⁵ is OH; R⁶ and R⁷ are H; and V¹, V² and V³ are -CH₂-)
[2-6] 1-(Meth)acryloyloxy-3,5-dihydroxyadamantane (R is H or CH₃; R⁵ and R⁶ are OH; R⁷ is H; and V¹, V² and V³ are -CH₂-)
[2-7] 1-(Meth)acryloyloxy-3,5,7-trihydroxyadamantane (R is H or CH₃, R⁵, R⁶ and R⁷ are OH; and V¹, V² and V³ are -CH₂-)
[2-8] 1-(Meth)acryloyloxy-3-hydroxy-5,7-dimethyladamantane (R is H or CH₃; R⁵ is OH; R⁶ and R⁷ are CH₃; and V¹, V² and V³ are -CH₂-)
[2-9] 1-(Meth)acryloyloxy-3-carboxyadamantane (R is H or CH₃; R⁵ is COOH; R⁶ and R⁷ are H; and V¹, V² and V³ are -CH₂-)

Each of the compounds represented by Formula (2a) can be prepared, for example, by reacting a corresponding cyclic alcohol derivative with (meth)acrylic acid or a reactive derivative thereof according to a conventional esterification procedure using an acid catalyst or a transesterification catalyst.

Typical examples of the compounds represented by Formula (2b) include the following compounds.
[2-10] 5-(Meth)acryloyloxy-3-oxatricyclo[4.2.1.0^{4,8}]nonan-2-one (i.e., 5-(meth)acryloyloxy-2,6-norbornanecarbolactone) (R is H or CH₃; and R⁸, R⁹, R¹⁰, R¹¹ and R¹² are H)
[2-11] 5-(Meth)acryloyloxy-5-methyl-3-oxatricyclo[4.2.1.0^{4,8}]nonan -2-one (R is H or CH₃; R⁸ is CH₃; and R⁹, R¹⁰, R¹¹ and R¹² are H)
[2-12] 5-(Meth)acryloyloxy-1-methyl-3-oxatricyclo[4.2.1.0^{4,8}]nonan -2-one (R is H or CH₃; R⁹ is CH₃; and R⁸, R¹⁰, R¹¹ and R¹² are H)
[2-13] 5-(Meth)acryloyloxy-9-methyl-3-oxatricyclo[4.2.1.0^{4,8}]nonan -2-one (R is H or CH₃; R¹⁰ is CH₃; and R⁸, R⁹, R¹¹ and R¹² are H)
[2-14] 5-(Meth)acryloyloxy-9-carboxy-3-oxatricyclo[4.2.1.0^{4,8}]nona n-2-one (R is H or CH₃; R⁸, R⁹, R¹¹ and R¹² are H; and R¹⁰ is COOH)
[2-15] 5-(Meth)acryloyloxy-9-methoxycarbonyl-3-oxatricyclo[4.2.1. 0^{4,8}]nonan-2-one (R is H or CH₃; R⁸, R⁹, R¹¹ and R¹² are H; and R¹⁰ is methoxycarbonyl group)
[2-16] 5-(Meth)acryloyloxy-9-ethoxycarbonyl-3-oxatricyclo[4.2.1.0 ^{4,8}]nonan-2-one (R is H or CH₃; R⁸, R⁹, R¹¹ and R¹² are H; and R¹⁰ is ethoxycarbonyl group)
[2-17] 5-(Meth)acryloyloxy-9-t-butoxycarbonyl-3-oxatricyclo[4.2.1 .0^{4,8}]nonan-2-one (R is H or CH₃; R⁸, R⁹, R¹¹ and R¹² are H; and R¹⁰ is t-butoxycarbonyl group)

Each of the compounds represented by Formula (2b) can be prepared, for example, by reacting a corresponding cyclic alcohol derivative with (meth)acrylic acid or a reactive derivative thereof according to a conventional esterification procedure using an acid catalyst or a transesterification catalyst. The cyclic alcohol derivative used as a raw material can be prepared, for example, by subjecting a corresponding 5-norbornene-2-carboxylic acid derivative or an ester thereof to reaction (epoxidation and cyclization) with a peracid or a peroxide. Examples of the peracid are peracetic acid and m-chloroperbenzoic acid. Examples of the peroxide are hydrogen peroxide or a mixture of hydrogen peroxide and a metal compound such as tungsten oxide or tungstic acid.

Typical examples of the compounds represented by Formula (2c) include the following compounds.
[2-18] 8-(Meth)acryloyloxy-4-oxatricyclo[5.2.1.0^{2,6}]decan-5-one (R is H or CH₃)
[2-19] 9-(Meth)acryloyloxy-4-oxatricyclo[5.2.1.0^{2,6}]decan-5-one (R is H or CH₃)

Each of the compounds represented by Formula (2c) can be prepared, for example, by reacting a corresponding cyclic alcohol derivative with (meth)acrylic acid or a reactive derivative thereof according to a conventional esterification procedure using an acid catalyst or a transesterification catalyst. Typical examples of the compounds represented by Formula (2d) include the following compounds.
[2-20] 4-(Meth)acryloyloxy-6-oxabicyclo[3.2.1]octan-7-one (R is H or CH₃; and R¹³, R¹⁴, R¹⁵, R¹⁶, R¹⁷, R¹⁸, R¹⁹, R²⁰ and R²¹ are H)
[2-21] 4-(Meth)acryloyloxy-4-methyl-6-oxabicyclo[3.2.1]octan-7-on e (R is H or CH_{3;} R¹⁴, R¹⁵, R¹⁶, R¹⁷, R¹⁸, R¹⁹, R²⁰ and R²¹ are H; and R¹³ is CH₃)
[2-22] 4-(Meth)acryloyloxy-5-methyl-6-oxabicyclo[3.2.1]octan-7-on e (R is H or CH₃; R¹³, R¹⁵, R¹⁶, R¹⁷, R¹⁸, R¹⁹, R²⁰ and R²¹ are H; and R¹⁴ is CH₃)
[2-23] 4-(Meth)acryloyloxy-4,5-dimethyl-6-oxabicyclo[3.2.1]octan-7-one (R is H or CH₃; R¹⁵, R¹⁶, R¹⁷, R¹⁸, R¹⁹, R²⁰ and R²¹ are H; and R¹³ and R¹⁴ are CH₃)

Typical examples of the compounds represented by Formula (2e) include the following compounds. [2-24] 6-(Meth)acryloyloxy-2-oxabicyclo[2.2.2]octan-3-one (R is H or CH₃; and R²², R²³, R²⁴, R²⁵, R²⁶, R²⁷, R²⁸, R²⁹ and R³⁰ are H)
[2-25] 6-(Meth)acryloyloxy-6-methyl-2-oxabicyclo[2.2.2]octan-3-on e (R is H or CH₃; R²², R²⁴, R²⁵, R²⁶, R²⁷, R²⁸, R²⁹ and R³⁰ are H; and R²³ is CH₃)
[2-26] 6-(Meth)acryloyloxy-1-methyl-2-oxabicyclo[2.2.2]octan-3-on e (R is H or CH₃; R²³, R²⁴, R²⁵, R²⁶, R²⁷, R²⁸, R²⁹ and R³⁰ are H; and R²² is CH₃)
[2-27] 6-(Meth)acryloyloxy-1,6-dimethyl-2-oxabicyclo[2.2.2]octan-3-one (R is H or CH₃; and R²⁴, R²⁵, R²⁶, R²⁷, R²⁸, R²⁹ and R³⁰ are H; and R²² and R²³ are CH₃)

Each of the compounds represented by Formulae (2d) and (2e) can be prepared, for example, by reacting a corresponding cyclic alcohol derivative with (meth) acrylic acid or a reactive derivative thereof according to a conventional esterification procedure using an acid catalyst or a transesterification catalyst.

The resulting polymer formed as a result of polymerization can be isolated by precipitation or reprecipitation. The target polymer, for example, can be obtained by adding a polymerization solution (polymer dope) to a solvent (precipitation solvent) to thereby precipitate a polymer, or by dissolving the precipitated polymer in an appropriate solvent to yield a solution, and adding the solution to a solvent (reprecipitation solvent) to thereby reprecipitate the polymer. The precipitation solvent or reprecipitation solvent may be any of organic solvents and water, or mixtures of these solvents. Examples of the organic solvents for use as the precipitation solvent or reprecipitation solvent are hydrocarbons including aliphatic hydrocarbons such as pentane, hexane, heptane and octane, alicyclic hydrocarbons such as cyclohexane and methylcyclohexane, and aromatic hydrocarbons such as benzene, toluene and xylenes; halogenated hydrocarbons including halogenated aliphatic hydrocarbons such as methylene chloride, chloroform and carbon tetrachloride, and halogenated aromatic hydrocarbons such as chlorobenzene and dichlorobenzene; nitro compounds such as nitromethane and nitroethane; nitriles such as acetonitrile and benzonitrile; ethers including open-chain ethers such as diethyl ether, diisopropyl ether and dimethoxyethane, and cyclic ethers such as tetrahydrofuran and dioxane; ketones such as acetone, methyl ethyl ketone and diisobutyl ketone; esters such as ethyl acetate and butyl acetate; carbonates such as dimethyl carbonate, diethyl carbonate, ethylene carbonate and propylene carbonate; alcohols such as methanol, ethanol, propanol, isopropanol and butanol; carboxylic acids such as acetic acid; and mixtures containing these solvents.

Among them, solvents each containing at least a hydrocarbon, preferably an aliphatic hydrocarbon such as hexane or heptane, are preferred as the organic solvents for use as the precipitation solvent or reprecipitation solvent. The ratio of the hydrocarbon (e.g., an aliphatic hydrocarbon such as hexane or heptane) to the other solvent (e.g., an ester such as ethyl acetate) in the solvent containing at least a hydrocarbon is, for example, from 10/90 to 99/1, preferably from 30/70 to 98/2 , and more preferably from 50/50 to 97/3 in terms of volume ratio at 25°C.

If desired, the polymer obtained by precipitation or reprecipitation is subjected to repulping and/or rinsing. It may be subjected to rinsing after repulping. By repulping and/or rinsing the polymer prepared by polymerization, residual monomers and low-molecular oligomers attached to the polymer can be removed efficiently. In addition, the resulting polymer particles have hardened surfaces and are prevented from fusing with each other during subsequent processes such as drying process. This is probably because a high-boiling solvent having affinity for the polymer has been removed. Thus, the polymer becomes significantly highly soluble in solvents for resist, which enables a photoresist resin compositions to be prepared easily and efficiently.

The solvent for repulping (repulping solvent) and the solvent for rinsing (rinsing solvent) are preferably poor solvents for the polymer which may be used in precipitation or reprecipitation. Among them, hydrocarbon solvents are typically preferred. Examples of such hydrocarbon solvents are alicyclic hydrocarbons such as pentane, hexane, heptane and octane; alicyclic hydrocarbons such as cyclohexane and methylcyclohexane; and aromatic hydrocarbons such as benzene, toluene and xylenes. Each of these can used in combination as a mixture. Among them, one or more alicyclic hydrocarbons are preferred, of which heptane or hexane, ormixtures containing hexane or heptane are typically preferred.

The amount of the repulping solvent is, for example, from 1 to 200 times by weight, and preferably from 5 to 100 times by weight, the weight of the polymer. The amount of the rinsing solvent is, for example, from 1 to 100 times by weight, and preferably from 2 to 20 times by weight, the weight of the polymer. The temperature for the repulping and/or rinsing is generally from 0°C to 100°C, and preferably from 10°C to 60°C, while varying depending typically on the type of a solvent to be used. The repulping and/or rinsing is carried out in an appropriate vessel. The repulping and rinsing procedures may be repeated plural times, respectively. The liquids after treatment (repulping liquid or rinsing liquid) are removed, for example, by decantation or filtration.

The resulting wet polymer after precipitation or reprecipitation, or further after repulping and/or rinsing according to necessity is then subjected to drying. The drying temperature is, for example, from 20°C to 120°C, and preferably from 40°C to 100°C. The drying is preferably carried out under reduced pressure at, for example, 200 mmHg (26.6 kPa) or less, and more preferably at 100 mmHg (13.3 kPa) or less.

The above-mentioned process yields a photoresist resin which has a weight-average molecular weight of 3000 to 15000 and has a content of polymer fractions each having a molecular weight exceeding 40000 of 4 percent by weight or less of the total resin. The weight-average molecular weight can be controlled by appropriately adjusting, for example, the monomer composition, amount of the polymerization initiator, polymerization temperature and/or polymerization time.

The turbidity of the resulting photoresist resin is generally from 0 to 10, preferably from 0 to 3, more preferably from 0 to 1, and typically preferably from 0 to 0.1. The turbidity herein is determined by mixing 1 gram of a sample photoresist resin with 19 grams of polypropylene glycol monomethyl ether acetate (PGMEA), shaking the resulting mixture at room temperature for 60 minutes to yield a resin mixture having a resin concentration of 5 percent by weight, and measuring the turbidity of the resin mixture according to Japanese Industrial Standards (JIS) K 0101 (integrating-sphere turbidity).

The photoresist resin composition comprises a light-activatable acid generator in addition to the photoresist resin. As the light-activatable acid generator, any of conventional or known compounds that efficiently generate an acid upon irradiation of light can be used. Examples of such compounds are diazonium salts; iodonium salts such as diphenyliodohexafluorophosphate; sulfonium salts such as triphenylsulfonium hexafluoroantimonate, triphenylsulfonium hexafluorophosphate and triphenylsulfonium methanesulfonate; sulfonic acid esters such as 1-phenyl-1-(4-methylphenyl)sulfonyloxy-1-benzoylmethane, 1,2,3-trisulfonyloxymethylbenzene, 1,3-dinitro-2-(4-phenylsulfonyloxymethyl)benzene and 1-phenyl-1-(4-methylphenylsulfonyloxymethyl)-1-hydroxy-1-b enzoylmethane; oxathiazole derivatives; s-triazine derivatives; disulfone derivatives such as diphenyl disulfone; imide compounds; oxime sulfonates; diazonaphthoquinone; and benzoin tosylate. Each of these light-activatable acid generators can be used alone or in combination.

The amount of the light-activatable acid generator can be appropriately set according to, for example, the intensity of an acid formed upon irradiation of light and/or the proportions of respective constitutional repeating units in the polymer (photoresist resin) and is, for example, from 0.1 to 30 parts by weight, preferably from 1 to 25 parts by weight, and more preferably from 2 to 20 parts by weight, to 100 parts by weight of the polymer.

The photoresist resin composition may further comprise any of other components. Examples of such components are alkali-soluble components including alkali-soluble resins such as novolak resins, phenol resins, imide resins and carboxyl-containing resins; coloring agents such as dyes; and organic solvents such as hydrocarbons, halogenated hydrocarbons, alcohols, esters, amides, ketones, ethers, Cellosolves, Carbitols, glycol ether esters, and mixtures of these solvents.

The photoresist resin composition can be prepared by dissolving the photoresist resin in a solvent (solvent for photoresist). More specifically, the photoresist resin composition can be prepared by adding the photoresist resin as intact, or after an appropriate purification procedure according to necessity, to an organic solvent, and mixing and stirring them together with a light-activatable acid generator and other components, if added.

A fine pattern can be formed with high accuracy by applying the resulting photoresist resin composition to a base or substrate to form a coating, drying the coating, applying radiation rays to the coating (resist film), or further baking after light irradiation, to form a latent image pattern, and developing the latent image pattern.

Examples of the base or substrate are silicon wafers, metals, plastics, glass and ceramics. The photoresist resin composition can be applied using a conventional coating device such as a spin coater, a dip coater or a roller coater. The thickness of the coating is, for example, from 0.1 to 20 µm, and preferably from 0.3 to 2 µm.

Radiation rays of various wavelengths, such as ultraviolet rays or X-rays, can be used for light irradiation (exposure) . For semiconductor resists, g-line, i-line or excimer laser such as XeCl, KrF, KrCl, ArF or ArCl is generally used. The exposure energy is, for example, from 1 to 1000 mJ/cm², and preferably from 10 to 500 mJ/cm².

The light-activatable acid generator generates an acid upon irradiation with light. By the action of the acid, a protective group (leaving group), for example, of a carboxyl group in the constitutional repeating unit capable of partially leaving by the action of an acid to thereby become soluble in an alkali in the photoresist resin rapidly leaves to thereby yield, for example, a carboxyl group that contributes to render the polymer soluble. Thus, a predetermined pattern can be formed accurately as a result of development with water or an alkali developing agent.

The present invention will be illustrated in further detail with reference to several examples below. The indication "acrylate" after a compound number (a monomer number) represents a compound having acryloyloxy group between two compounds corresponding to the compound number described in the description, and the indication "methacrylate" represents a compound having methacryloyl group between the two compounds. The weight-average molecular weight (Mw), the molecular weight distribution (Mw/Mn) and the content of polymer fractions each having a molecular weight exceeding 40000 were determined in terms of standard polystyrene by GPC using a refractometer (RI) as a detector and tetrahydrofuran (THF) as an eluent. The GPC determination was carried out using three columns "Shodex KF-806L" (trade name) available from Showa Denko K. K. connected in series under conditions at a sample concentration of 0.5%, amount of injected sample of 35 µm, column temperature of 40°C, RI temperature of 40°C, flow rate of eluent of 0.8 ml/min., and analysis time of 60 minutes. An apparatus "GPCLC-10A" available from Shimadzu Corporation was used as a GPC analyzer.

### EXAMPLE 1

### Preparation of Photoresist Resin Having the Following Structure

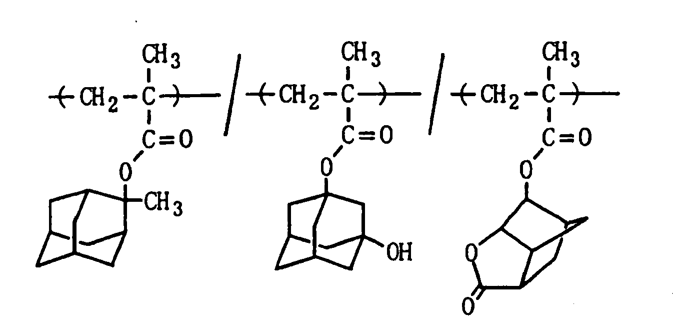

In a reactor equipped with a stirrer, a thermometer, a reflux condenser, two dropping vessels and a nitrogen inlet tube was charged 2500 g of propylene glycol monomethyl ether acetate (PGMEA) and was heated to 77°C. A monomer solution and a polymerization initiator solution were then added dropwise to the reactor from different dropping vessels using metering pumps, respectively, over six hours. The monomer solution contained 500 g of 1-hydroxy-3-methacryloyloxyadamantane (HMA) [Compound Number [2-5] (methacrylate)], 500 g of 5-methacryloyloxy-2,6-norbornanecarbolactone (MNBL) [Compound Number [2-10] (methacrylate)] and 500 g of 2-methacryloyloxy-2-methyladamantane (2MMA) [Compound Number [1-1] (methacrylate)] dissolved in 4000 g of propylene glycol monomethyl ether acetate (PGMEA). The polymerization initiator solution contained 93 g of dimethyl-2,2'-azobis(2-methylpropionate) (initiator; V-601, available from Wako Pure Chemical Industries, Ltd.) dissolved in 900 g of propylene glycol monomethyl ether acetate (PGMEA). As the temperature gradually fell after the begging of dropping, the preset temperature of a control system was gradually reduced to 75°C and was held to 75°C thereafter. The liquid temperature fell from 77°C to 75°C in ten minutes after the begging of dropping. The polymerization temperature (temperature of the reaction mixture) could be held within 75°C±1°c from ten minutes to six hours after the begging of the dropping. After the completion of dropping, the reaction mixture was aged at the same temperature for two hours. The polymerization reaction mixture was added dropwise to a mixture containing 65000 g of heptane and 21500 g of ethyl acetate at ordinary temperature, followed by stirring for thirty minutes and standing still for ninety minutes. The supernatant was taken out, and the residue was mixed with 64000 g of heptane, followed by repulping at ordinary temperature. This procedure was carried out a total of two times. The residue from which the supernatant had been taken out was transferred to a centrifugal separator, followed by drainage by the action of centrifugal force, to yield a wet polymer. The wet polymer was mixed with 6500 g of heptane, was rinsed in a centrifugal separator, and the rinsing liquid was removed. The resulting wet polymer was taken out, was subjected to vacuum drying at 50°C, 20mmHg (2.66kPa) and thereby yielded 100 g of the target resin. The recovered resin was subjected to GPC analysis and was found to have a weight-average molecular weight (Mw) of 9100, a molecular weight distribution (Mw/Mn) of 1.8, and a content of polymer fractions each having a molecular weight exceeding 40000 of 1.2 percent by weight.

### EXAMPLE 2

### Preparation of Photoresist Resin Having the same Structure as Example 1

In a separable flask equipped with a stirrer, a thermometer, a reflux condenser, two dropping funnels and a nitrogen inlet tube was charged 25 g of propylene glycol monomethyl ether acetate (PGMEA) and was heated to 77°C. A monomer solution and a polymerization initiator solution were then added dropwise to the separable flask from different dropping funnels, respectively, over six hours. The monomer solution contained 5 g of 1-hydroxy-3-methacryloyloxyadamantane (HMA) [Compound Number [2-5] (methacrylate)], 5 g of 5-methacryloyloxy-2,6-norbornanecarbolactone (MNBL) [Compound Number [2-10] (methacrylate)] and 5 g of 2-methacryloyloxy-2-methyladamantane (2MMA) [Compound Number [1-1] (methacrylate)] dissolved in 40 g of propylene glycol monomethyl ether acetate (PGMEA). The polymerization initiator solution contained 0.93 g of dimethyl-2,2'-azobis(2-methylpropionate) (initiator; V-601, available from Wako Pure Chemical Industries, Ltd.) dissolved in 9 g of propylene glycol monomethyl ether acetate (PGMEA). As the temperature gradually fell after the begging of dropping, the preset temperature of a control system was gradually reduced to 75°C and was held to 75°C thereafter. The liquid temperature fell from 77°C to 75°C in ten minutes after the begging of dropping. The polymerization temperature (temperature of the reaction mixture) could be held within 75°C±1°c from ten minutes to six hours after the begging of the dropping. After the completion of dropping, the reaction mixture was aged at the same temperature for two hours. The polymerization reaction mixture was added dropwise to a mixture containing 650 g of heptane and 215 g of ethyl acetate at ordinary temperature, followed by stirring for thirty minutes and standing still for ninety minutes. The supernatant was taken out, and the residue was mixed with 640 g of heptane, followed by repulping at ordinary temperature. This procedure was carried out a total of two times. The residue from which the supernatant had been taken out was transferred to a centrifugal separator, followed by drainage by the action of centrifugal force, to yield a wet polymer. The wet polymer was mixed with 65 g of heptane, was rinsed in a centrifugal separator, and the rinsing liquid was removed. The resulting wet polymer was taken out, was subjected to vacuum drying at 50°C, 20 mmHg (2.66 kPa) and thereby yielded 11 g of the target resin. The recovered resin was subjected to GPC analysis and was found to have a weight-average molecular weight (Mw) of 9100, a molecular weight distribution (Mw/Mn) of 1.8, and a content of polymer fractions each having a molecular weight exceeding 40000 of 1.2 percent by weight.

### COMPARATIVE EXAMPLE 1

### Preparation of Photoresist Resin Having the same Structure as Example 1

In a separable flask equipped with a stirrer, a thermometer, a reflux condenser, a dropping funnel and a nitrogen inlet tube was charged 33 g of propylene glycol monomethyl ether acetate (PGMEA) and was heated to 75°C. A solution mixture was then added dropwise to the separable flask from the dropping funnel over six hours. The solution mixture contained 5 g of 1-hydroxy-3-methacryloyloxyadamantane (HMA) [Compound Number [2-5] (methacrylate)], 5 g of 5-methacryloyloxy-2,6-norbornanecarbolactone (MNBL) [Compound Number [2-10] (methacrylate)], 5 g of 2-methacryloyloxy-2-methyladamantane (2MMA) [Compound Number [1-1] (methacrylate)], 0.93 g of dimethyl-2,2'-azobis(2-methylpropionate) (initiator; V-601, available from Wako Pure Chemical Industries, Ltd.) and 41 g of propylene glycol monomethyl ether acetate (PGMEA). The temperature was controlled while setting the preset temperature of the control system at 75°C. However, the liquid temperature significantly fell below 70°C at the begging of dropping. Thus, the deviation of the polymerization temperature (temperature of reaction mixture) was out of a range of ±5°C of the preset temperature 75°C during the first thirty minutes (8.3% of the total dropping time) of the total dropping time (six hours) of the mixture solution containing the monomers and the polymerization initiator. The polymerization temperature (temperature of the reaction mixture) could be held within 75°C±1°c from thirty minutes after the begging of the dropping. After the completion of dropping, the reaction mixture was aged at the same temperature for two hours. The polymerization reaction mixture was added dropwise to a mixture containing 650 g of heptane and 215 g of ethyl acetate at ordinary temperature, followed by stirring for thirty minutes and standing still for ninety minutes. The supernatant was taken out, and the residue was mixed with 640 g of heptane, followed by repulping at ordinary temperature. This procedure was carried out a total of two times. The residue from which the supernatant had been taken out was transferred to a centrifugal separator, followed by drainage by the action of centrifugal force, to yield a wet polymer. The wet polymer was mixed with 65 g of heptane, was rinsed in a centrifugal separator, and the rinsing liquid was removed. The resulting wet polymer was taken out, was subjected to vacuum drying at 50°C, 20 mmHg (2.66 kPa) and thereby yielded 10 g of the target resin. The recovered resin was subjected to GPC analysis and was found to have a weight-average molecular weight (Mw) of 9700, a molecular weight distribution (Mw/Mn) of 3.1, and a content of polymer fractions each having a molecular weight exceeding 40000 of 4.7 percent by weight.

### Evaluation Test

Each 1 gram of the resins obtained according to the examples and comparative example was mixed with 19 grams of propylene glycol monomethyl ether acetate (PGMEA), followed by shaking at room temperature for sixty minutes, to yield resin mixtures each having a resin concentration of 5 percent by weight. The turbidities of the resin mixtures were determined according to JIS K 0101 (integrating-sphere turbidity) using a haze turbidimeter [trade name of "NDH 300A", available from Nippon Denshoku Industries Co., Ltd.]. The resins according to Examples 1 and 2 each had a turbidity of 0.0, and the resin according to Comparative Example 1 had a turbidity of 13.3, showing that there was a significant difference between the two.

## Claims

1. A process for preparing a photoresist resin comprising at least a constitutional repeating unit A containing a group capable of partially leaving by the action of an acid to thereby become soluble in an alkali; and a constitutional repeating unit B containing an alicyclic skeleton having a polar group, wherein the resin has a weight-average molecular weight of 3000 to 15000 and has a content of polymer fractions each having a molecular weight exceeding 40000 of 4 percent by weight or less of the total resin said process comprising the step of adding a solution of monomers and a solution of a polymerization initiator dropwise from different vessels in dropping polymerization, said solution of monomers comprising a monomer "a" corresponding to the constitutional repeating unit A, and a monomer "b" corresponding to the constitutional repeating unit B.

2. The process of claim 1, wherein the constitutional repeating unit A is at least one selected from constitutional repeating units of the following Formulae (Ia), (Ib) and (Ic): 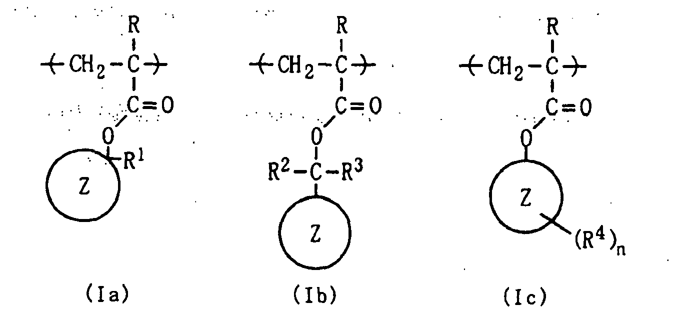 wherein the ring Z is an alicyclic hydrocarbon ring having six to twenty carbon atoms which may be substituted; R is a hydrogen atom or an alkyl group having one to six carbon atoms; R¹, R² and R³ may be the same as or different from one another and are each an alkyl group having one to six carbon atoms; R⁴s are substituents combined with the ring Z, may be the same as or different from each other and are each an oxo group, an alkyl group, a hydroxyl group which may be protected by a protective group, a hydroxyalkyl group which may be protected by a protective group, or a carboxyl group which may be protected by a protective group, and wherein at least one of nR⁴s is a -COOR^{a} group, wherein R^{a} is a tertiary hydrocarbon group which may be substituted, a tetrahydrofuranyl group, a tetrahydropyranyl group or an oxepanyl group; and n is an integer of 1 to 3.

3. The process of claim 1 or 2, wherein the constitutional repeating unit B is at least one selected from constitutional repeating units of the following Formulae (IIa), (IIb), (IIc), (IId) and (IIe): 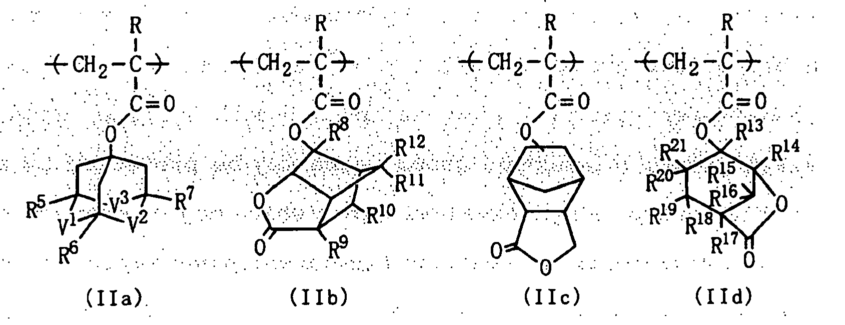 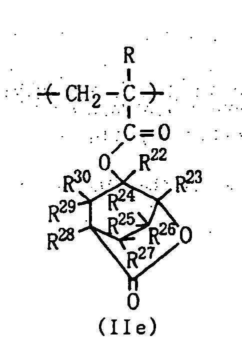 wherein R is a hydrogen atom or an alkyl group having one to six carbon atoms; R⁵, R⁶ and R⁷ may be the same as or different from one another and are each a hydrogen atom, an alkyl group, a hydroxyl group which may be protected by a protective group, a hydroxyalkyl group which may be protected by a protective group, or a carboxyl group which may be protected by a protective group; V¹, V² and V³ may be the same as or different from one another and are each -CH₂-, -CO- or -COO-, wherein (i) at least one of V¹, V² and V³ is -CO- or -COO-, or (ii) at least one of R⁵, R⁶ and R⁷ is a hydroxyl group which may be protected by a protective group, a hydroxyalkyl group which may be protected by a protective group, or a carboxyl group which may be protected by a protective group; R⁸, R⁹, R¹⁰, R¹¹ and R¹² may be the same as or different from one another and are each a hydrogen atom, an alkyl group, a hydroxyl group which may be protected by a protective group, a hydroxyalkyl group which may be protected by a protective group, or a carboxyl group which may be protected by a protective group; R¹³, R¹⁴, R¹⁵, R¹⁶, R¹⁷, R¹⁸ R¹⁹, R²⁰ and R²¹ may be the same as or different from one another and are each a hydrogen atom, an alkyl group, a hydroxyl group which may be protected by a protective group, a hydroxyalkyl group which may be protected by a protective group, or a carboxyl group which may be protected by a protective group; and R²², R²³, R²⁴, R²⁵, R²⁶, R²⁷, R²⁸, R²⁹ and R³⁰ may be the same as or different from one another and are each a hydrogen atom, an alkyl group, a hydroxyl group which may be protected by a protective group, a hydroxyalkyl group which may be protected by a protective group, or a carboxyl group which may be protected by a protective group.

## Patentansprüche

1. Verfahren zum Herstellen eines Fotoresistharzes, umfassend wenigstens eine konstitutionelle Wiederholungseinheit A, die eine Gruppe enthält, die unter der Einwirkung einer Säure teilweise abgespalten werden kann, um **dadurch** in einem Alkali löslich zu werden; und eine konstitutionelle Wiederholungseinheit B, die ein alicyclisches Gerüst mit einer polaren Gruppe enthält, wobei das Harz ein gewichtsgemitteltes Molekulargewicht von 3000 bis 15000 aufweist und einen Gehalt an Polymerfraktionen, die jeweils ein Molekulargewicht von mehr als 40000 aufweisen, von 4 Gew.-% oder weniger, bezogen auf das gesamte Harz, aufweist, wobei das Verfahren den Schritt des Zugebens einer Lösung von Monomeren und einer Lösung eines Polymerisationsinitiators tropfenweise aus verschiedenen Gefäßen in einer Tropfpolymerisation umfasst, wobei die Lösung von Monomeren ein Monomer "a", das der konstitutionellen Wiederholungseinheit A entspricht, und ein Monomer "b", das der konstitutionellen Wiederholungseinheit B entspricht, umfasst.

2. Verfahren nach Anspruch 1, wobei die konstitutionelle Wiederholungseinheit A wenigstens eine Einheit ist, die ausgewählt ist aus konstitutionellen Wiederholungseinheiten der folgenden Formeln (Ia), (Ib) und (Ic): 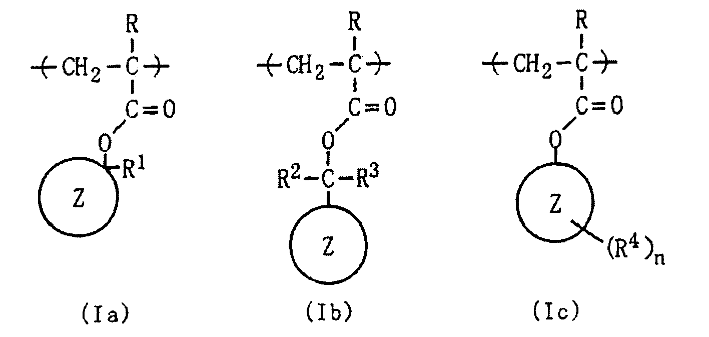 worin der Ring Z ein alicyclischer Kohlenwasserstoffring mit sechs bis zwanzig Kohlenstoffatomen ist, welcher substituiert sein kann; R ein Wasserstoffatom oder eine Alkylgruppe mit ein bis sechs Kohlenstoffatomen ist; R¹, R² und R³ gleich oder voneinander verschieden sein können und jeweils eine Alkylgruppe mit ein bis sechs Kohlenstoffatomen sind; die R⁴ Substituenten sind, die mit dem Ring Z kombiniert sind, gleich oder voneinander verschieden sein können und jeweils eine Oxogruppe, eine Alkylgruppe, eine Hydroxylgruppe, welche durch eine Schutzgruppe geschützt sein kann, eine Hydroxyalkylgruppe, welche durch eine Schutzgruppe geschützt sein kann, oder eine Carboxylgruppe, welche durch eine Schutzgruppe geschützt sein kann, sind und worin wenigstens eines von nR⁴ eine -COOR^{a} -Gruppe ist, wobei R^{a} eine tertiäre Kohlenwasserstoffgruppe, welche substituiert sein kann, eine Tetrahydrofuranylgruppe, eine Tetrahydropyranylgruppe oder eine Oxepanylgruppe ist; und n eine ganze Zahl von 1 bis 3 ist.

3. Verfahren nach Anspruch 1 oder 2, worin die konstitutionelle Wiederholungseinheit B wenigstens eine Einheit ist, die ausgewählt ist aus konstitutionellen Wiederholungseinheiten der folgenden Formeln (IIa), (IIb), (IIc), (IId) und (IIe): 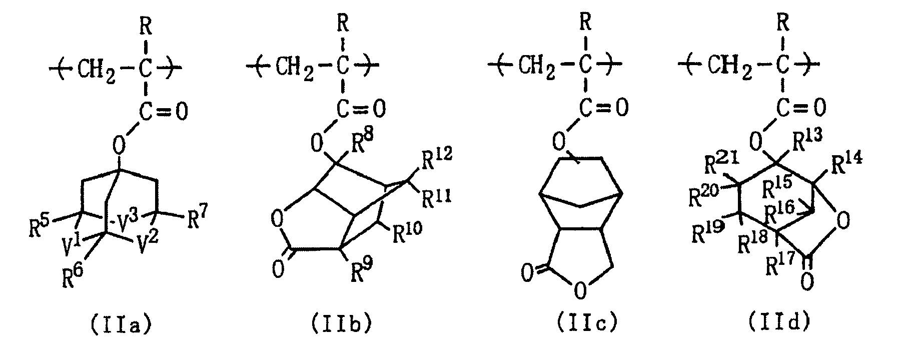 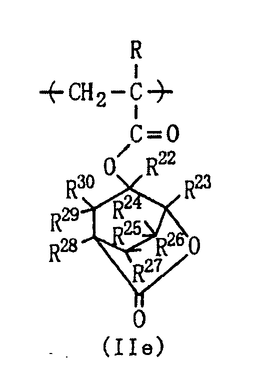 worin R ein Wasserstoffatom oder eine Alkylgruppe mit ein bis sechs Kohlenstoffatomen ist; R⁵, R⁶ und R⁷ gleich oder voneinander verschieden sein können und jeweils ein Wasserstoffatom, eine Alkylgruppe, eine Hydroxylgruppe, welche durch eine Schutzgruppe geschützt sein kann, eine Hydroxyalkylgruppe, welche durch eine Schutzgruppe geschützt sein kann, oder eine Carboxylgruppe, welche durch eine Schutzgruppe geschützt sein kann, sind; V¹, V² und V³ gleich oder voneinander verschieden sein können und jeweils -CH₂-, -CO- oder -COO- sind, wobei (i) wenigstens eines von V¹, V² und V³ -CO- oder -COO- ist, oder (ii) wenigstens eines von R⁵, R⁶ und R⁷ eine Hydroxylgruppe, welche durch eine Schutzgruppe geschützt sein kann, eine Hydroxyalkylgruppe, welche durch eine Schutzgruppe geschützt sein kann, oder eine Carboxylgruppe, welche durch eine Schutzgruppe geschützt sein kann, ist; R⁸, R⁹, R¹⁰, R¹¹ und R¹² gleich oder voneinander verschieden sein können und jeweils ein Wasserstoffatom, eine Alkylgruppe, eine Hydroxylgruppe, welche durch eine Schutzgruppe geschützt sein kann, eine Hydroxyalkylgruppe, welche durch eine Schutzgruppe geschützt sein kann, oder eine Carboxylgruppe, welche durch eine Schutzgruppe geschützt sein kann, sind; R¹³, R¹⁴, R¹⁵, R¹⁶, R¹⁷, R¹⁸, R¹⁹, R²⁰ und R²¹ gleich oder voneinander verschieden sein können und jeweils ein Wasserstoffatom, eine Alkylgruppe, eine Hydroxylgruppe, welche durch eine Schutzgruppe geschützt sein kann, eine Hydroxyalkylgruppe, welche durch eine Schutzgruppe geschützt sein kann, oder eine Carboxylgruppe, welche durch eine Schutzgruppe geschützt sein kann, sind; und R²², R²³, R²⁴, R²⁵, R²⁶, R²⁷, R²⁸, R²⁹ und R³⁰ gleich oder voneinander verschieden sein können und jeweils ein Wasserstoffatom, eine Alkylgruppe, eine Hydroxylgruppe, welche durch eine Schutzgruppe geschützt sein kann, eine Hydroxyalkylgruppe, welche durch eine Schutzgruppe geschützt sein kann, oder eine Carboxylgruppe, welche durch eine Schutzgruppe geschützt sein kann, sind.

## Revendications

1. Procédé pour préparer une résine de photorésist comprenant au moins une unité constitutionnelle répétitive A comprenant un groupe capable d'être séparé partiellement par l'action d'un acide pour devenir ainsi soluble dans un alcali ; et une unité constitutionnelle répétitive B comprenant un squelette alicyclique ayant un groupe polaire, où la résine a un poids moléculaire moyen en poids de 3000 à 15 000 et a une teneur en fractions de polymère ayant chacune un poids moléculaire excédant 40 000 de 4 % en poids ou moins de la résine totale, ledit procédé comprenant l'étape d'addition d'une solution de monomères et d'une solution d'un initiateur de polymérisation goutte-à-goutte à partir de différents récipients pour une polymérisation goutte-à-goutte, ladite solution de monomères comprenant un monomère « a » correspondant à l'unité constitutionnelle répétitive A, et un monomère « b » correspondant à l'unité constitutionnelle répétitive B.

2. Procédé selon la revendication 1, dans lequel l'unité constitutionnelle répétitive A est au moins une unité choisie parmi des unités constitutionnelles répétitives de formules suivantes (Ia), (Ib) et (Ic) : 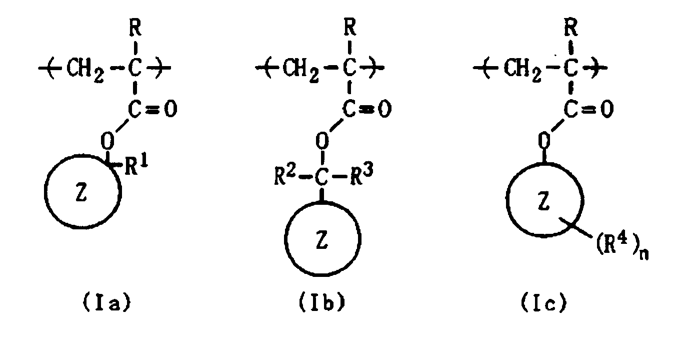 où le cycle Z est un cycle hydrocarbure alicyclique ayant de six à vingt atomes de carbone qui peuvent être substitués ; R est un atome d'hydrogène ou un groupe alkyle ayant un à six atomes de carbone ; R¹, R² et R³ peuvent être identiques ou différents les uns des autres et sont chacun un groupe alkyle ayant un à six atomes de carbone ; R⁴ sont des substituants combinés avec le cycle Z, ils peuvent être identiques ou différents les uns des autres et sont chacun un groupe oxo, un groupe alkyle, un groupe hydroxyle qui peut être protégé par un groupe protecteur, un groupe hydroxylalkyle qui peut être protégé par un groupe protecteur, ou un groupe carboxyle qui peut être protégé par un groupe protecteur, et où au moins l'un des nR⁴ est un groupe -COOR^{a}, où R^{a} est un groupe hydrocarbure tertiaire qui peut être substitué, un groupe tétrahydrofuranyle, un groupe tétrahydropyranyle ou un groupe oxépanyle ; et n est un entier de 1 à 3.

3. Procédé selon la revendication 1 ou 2, dans lequel l'unité constitutionnelle répétitive B est au moins une unité sélectionnée parmi des unités constitutionnelles répétitives de formules suivantes (IIa), (IIb), (IIc), (IId) et (IIe) : 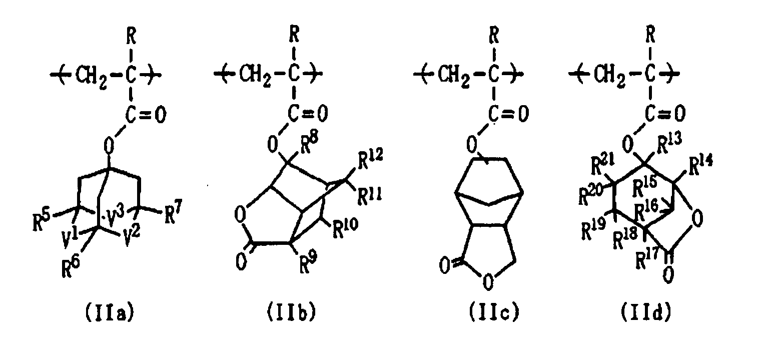 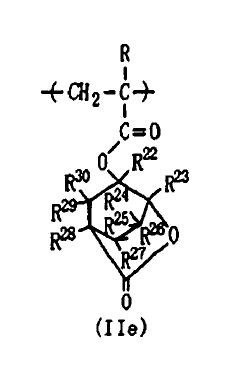 où R est un atome d'hydrogène ou un groupe alkyle ayant un à six atomes de carbone ; R⁵, R⁶ et R⁷ peuvent être identiques ou différents les uns des autres et sont chacun un atome d'hydrogène, un groupe alkyle, un groupe hydroxyle qui peut être protégé par un groupe protecteur, un groupe hydroxyalkyle qui peut être protégé par un groupe protecteur, ou un groupe carboxyle qui peut être protégé par un groupe protecteur ; V¹, V² et V³ peuvent être identiques ou différents les uns des autres et sont chacun -CH₂-, -CO- ou -COO-, où (i) au moins l'un parmi V¹, V² et V³ est -CO- ou -COO-, ou (ii) au moins l'un parmi R⁵, R⁶ et R⁷ est un groupe hydroxyle qui peut être protégé par un groupe protecteur, un groupe hydroxyalkyle qui peut être protégé par un groupe protecteur, ou un groupe carboxyle qui peut être protégé par un groupe protecteur ; R⁸, R⁹, R¹⁰, R¹¹ et R¹² peuvent être identiques ou différents les uns des autres et sont chacun un atome d'hydrogène, un groupe alkyle, un groupe hydroxyle qui peut être protégé par un groupe protecteur, un groupe hydroxyalkyle qui peut être protégé par un groupe protecteur, ou un groupe carboxyle qui peut être protégé par un groupe protecteur ; R¹³, R¹⁴, R¹⁵, R¹⁶, R¹⁷, R¹⁸, R¹⁹, R²⁰ et R²¹ peuvent être identiques ou différents les uns des autres et sont chacun un atome d'hydrogène, un groupe alkyle, un groupe hydroxyle qui peut être protégé par un groupe protecteur, un groupe hydroxyalkyle qui peut être protégé par un groupe protecteur, ou un groupe carboxyle qui peut être protégé par un groupe protecteur ; et R²², R²³, R²⁴, R²⁵, R²⁶, R²⁷, R²⁸, R²⁹ et R³⁰ peuvent être identiques ou différents les uns des autres et sont chacun un atome d'hydrogène, un groupe alkyle, un groupe hydroxyle qui peut être protégé par un groupe protecteur, un groupe hydroxyalkyle qui peut être protégé par un groupe protecteur, ou un groupe carboxyle qui peut être protégé par un groupe protecteur.
